# EUROPÄISCHE PATENTSCHRIFT

(11) **EP 2 182 609 B1**
(45) Veröffentlichungstag und Bekanntmachung des Hinweises auf die Patenterteilung: **13.01.2016**
(21) Anmeldenummer: 09171630.8
(22) Anmeldetag: 29.09.2009
(51) Int. Cl.: H02J 9/06, G01R 15/00, H02J 3/06, H02J 3/38, G01R 1/20, G01R 19/00

(54) **Stromkreis**
Electrical circuit
Circuit électrique

(30) Priorität: 29.10.2008 DE 102008055652
(43) Veröffentlichungstag der Anmeldung: 05.05.2010
(73) Patentinhaber: Siemens Aktiengesellschaft, 80333 München (DE)
(72) Erfinder: Walter, Harald, 12557, Berlin (DE)

(56) Entgegenhaltungen:
- DE-A1- 2 627 936
- DE-C- 335 120
- US-A- 4 922 364
- US-A- 5 815 387
- US-B1- 6 465 911

## Beschreibung

Die Erfindung betrifft eine Schaltung zum stromkreisunterbrechungsfreien Einbau und Ausbau einer Überwachungseinheit in einen Stromkreis zur signaltechnisch sicheren Ansteuerung von Weichen einer Eisenbahnanlage.

Zur Erhöhung der Verfügbarkeit von elektrischen Weichenstellsystemen der Eisenbahn ist die rechtzeitige Erkennung von Schwergängigkeiten, Wartungszuständen und mit Wahrscheinlichkeit eintretender Schäden von entscheidender Bedeutung. Durch die Erfassung, Bewertung und Analyse elektrischer Messgrößen, vorzugsweise Strom und Spannung, mittels der Überwachungseinheit kann eine Aussage über den Zustand des Weichenstellsystems getroffen werden.

Für die Strommessung werden in der Regel Durchsteckwandler verwendet, durch die die Adern des Weichenantriebskabels hindurchgeführt werden. Eine Montage oder Demontage des Durchsteckwandlers, beispielsweise bei Schäden an diesem Bauteil, ist ohne Unterbrechung des Stromkreises für die Weichenansteuerung nicht möglich. Die Stromkreisunterbrechung führt zu weitgehenden Abschaltungen in einem Stellwerk und letztlich zu erheblicher Beeinträchtigung der Verfügbarkeit und des Betriebsablaufes. Die Wiederherstellung des normalen Betriebszustandes ist mit erheblichen Schalthandlungen, Überprüfungen und Protokollierungen verbunden.

Um ein Auftrennen des Weichenstromkreises zum Tausch eines defekten Durchsteckwandlers zu vermeiden, wurden - speziell für diesen Anwendungsfall - Klappwandler entwickelt. Zum Ausbauen oder Tauschen lässt sich dieser aufklappen, so dass die Adern des Antriebskabels entnommen werden können. Nachteilig ist jedoch der hohe mechanische und elektromagnetische Aufwand, der mit dem Klappmechanismus verbunden ist, so dass Klappwandler sehr teuer sind und außerdem nur für einen punktuellen Stromwandlungsbereich zur Verfügung stehen.

Bekannt sind außerdem Überbrückungsschaltungen, um den Stromfluss umzuleiten, wie beispielsweise in DE 26 27 936, US 5,815,387 und US 6,465,911 beschrieben.

Der Erfindung liegt die Aufgabe zugrunde, eine unterbrechungsfreie Weichenbestromung bei Ein- oder Ausbau einer Überwachungseinheit auf einfache Weise zu ermöglichen. Dabei ist sicherzustellen, dass die Überwachungseinheit nicht irrtümlich ausgebaut werden kann.

Die Aufgabe wird durch den Gegenstand des Anspruchs gelöst.

Auf diese Weise ist ein gefahrloser Ein- und Ausbau der Überwachungseinheit durch allpolige Abschaltung möglich. Insbesondere ergibt sich der Vorteil, dass auch eine nicht aufklappbare Überwachungseinheit auf einfache Weise ausgetauscht werden kann, ohne den Stromkreis, in den die Überwachungseinheit eingebunden ist, zu unterbrechen. Dabei ist vorgesehen, dass die ersten Schalter und der zweite Schalter derart mittels eines Umschalters betätigbar sind, dass ausgehend von geöffneten ersten Schaltern und geschlossenem zweiten Schalter zuerst die ersten Schalter schließen und dann der zweite Schalter öffnet und ausgehend von geschlossenen ersten Schaltern und geöffnetem zweiten Schalter zuerst der zweite Schalter schließt und dann die ersten Schalter öffnen. Der Umschalter realisiert folglich in der jeweiligen Schaltrichtung voreilende Schalter, wodurch der Stromfluss während der Umschaltung erhalten bleibt, aber nach Abschluss des Schaltvorganges eine Trennung des ursprünglichen Schaltkreises vorliegt. Der Umschalter ist dabei derart ausgebildet und angeordnet, dass die Überwachungseinheit nur bei geöffneten ersten Schaltern und damit geschlossenem zweiten Schalter aus dem Stromkreis herausnehmbar ist. Ein versehentliches Herausnehmen der Überwachungseinheit, ohne dass der Umschalter den zweiten Schalter in der Schaltbrücke und damit einen Bypasszweig geschlossen hat, wird mechanisch verhindert. Dazu kann der Umschalter einen Bedienknebel aufweisen, der die Überwachungseinheit bei entsprechender Bedienknebelstellung mechanisch verriegelt oder verdeckt. Der überstehende Bedienknebel schließt eine Fehlhandlung durch unzeitige oder vorzeitige Demontage der Überwachungseinheit praktisch aus.

Die Erfindung wird nachfolgend anhand figürlicher Darstellungen erläutert. Es zeigen:
- Figur 1: eine Stromkreisanbindung eines Umschalters in einer ersten Schaltposition,
- Figur 2: eine Stromkreisanbindung des Umschalters nach Figur 1 in einer zweiten Schaltposition,
- Figur 3: eine umschalterinterne Verkabelung und
- Figur 4: eine Umschalterkonfiguration.

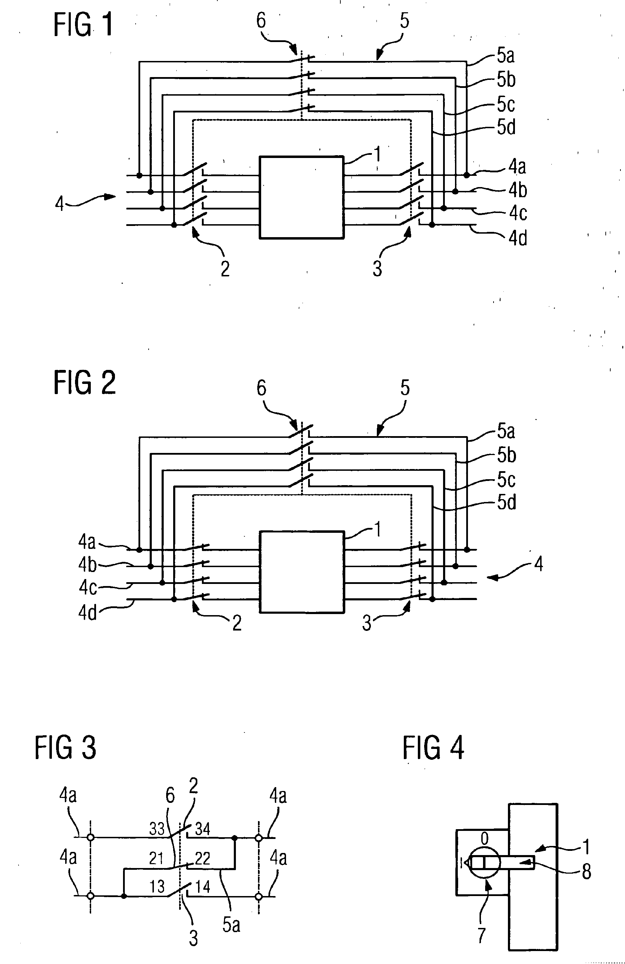

Die Figuren 1 und 2 zeigen eine Überwachungseinheit 1 für ein Weichenstellsystem. Die Überwachungseinheit 1 ist eingangsseitig und ausgangsseitig mit ersten Schaltern 2 und 3 verbunden. Die ersten Schalter 2 und 3 sind gleichzeitig und gleichwirkend betätigbar, wobei alle Adern 4a, 4b, 4c und 4d eines ausschnittsweise dargestellten Stromkreises 4 einbezogen sind. Eine Schaltbrücke 5 mit Adern 5a, 5b, 5c und 5d und einen zweiten Schalter 6 ist beidendig mit den entsprechenden Adern 4a, 4b, 4c und 4d des Stromkreises 4 zur Überbrückung der Überwachungseinheit 1 und der ersten Schalter 2 und 3 bypassartig verbunden. Die beiden ersten Schalter 2 und 3 und der zweite Schalter 6 sind durch einen Umschalter 7 (Figur 4) zwischen zwei Positionen gemäß Figur 1 und Figur 2 umschaltbar. Dabei erfolgt die Umschaltung derart, dass der Stromkreis 4 immer geschlossen ist, nämlich entweder bei eingebundener Überwachungseinheit 1 und geschlossenen ersten Schaltern 2 und 3 - Figur 2 - oder über die Schaltbrücke 5 bei geschlossenem zweiten Schalter 6 - Figur 1. Die während des Umschaltvorganges in der jeweiligen Schaltrichtung zu schließenden Schalter 2 und 3 oder 6 werden dazu nach Art voreilender Kontakte geringfügig vor den zu öffnenden Schaltern 6 oder 2 und 3 geschlossen. Bei der Schaltstellung, die in Figur 1 veranschaulicht ist, kann die Überwachungseinheit 1 aus dem Stromkreis 4 entfernt werden.

Figur 3 zeigt eine Verschaltung für eine Ader 4a/5a, d. h. für eine Phase, innerhalb des Umschalters 7. Die Aderbrücke 5a ist dabei interner Bestandteil des Umschalters 7. Diese Adernverschaltung ist in dem Umschalter 7 viermal vorgesehen.

Bei der in Figur 4 dargestellten Umschalterkonfiguration ist dafür gesorgt, dass der Umschalter 7 bei angeschalteter Überwachungseinheit 1 gemäß Figur 2 durch Stellung eines Bedienknebels 8 verhindert, dass die Überwachungseinheit 1 irrtümlich entfernt werden kann. Erst nach Drehung des Bedienknebels um 90°, verbunden mit der Umschaltung in den Schaltzustand gemäß Figur 1 wird die Entfernung der Überwachungseinheit 1 nicht mehr durch den Bedienknebel 8 blockiert.

## Patentansprüche

1. Schaltung zum stromkreisunterbrechungsfreien Einbau und Ausbau einer Überwachungseinheit (1) in einen Stromkreis zur signaltechnisch sicheren Ansteuerung von Weichen einer Eisenbahnanlage,
**gekennzeichnet durch,**
- eine Reihenschaltung, bestehend aus der Überwachungseinheit (1) und beidseitig der Überwachungseinheit (1) angeordneten ersten Schaltern (2 und 3),
- eine Schaltbrücke (5), die einen zweiten Schalter (6) aufweist und die Reihenschaltung überbrückt, und
- einen Bedienknebel (8), der das Entfernen der Überwachungseinheit (1) blockiert, falls sich die ersten Schalter (2 und 3) in geschlossener Stellung befinden,
- wobei die ersten Schalter (2 und 3) und der zweite Schalter (6) derart mittels eines mit dem Bedienknebel verbundenen Umschalters (7) betätigbar sind, dass ausgehend von geöffneten ersten Schaltern (2 und 3) und geschlossenem zweiten Schalter (6) zuerst die ersten Schalter (2 und 3) schließen und dann der zweite Schalter (6) öffnet und ausgehend von geschlossenen ersten Schaltern (2 und 3) und geöffnetem zweiten Schalter (6) zuerst der zweite Schalter (6) schließt und dann die ersten Schalter (2 und 3) öffnen.

## Claims

1. Circuit for interruption-free installation and removal of a monitoring unit (1) in an electrical circuit for the fail-safe control of points of a railway system,
**characterised by**
- a series circuit comprising the monitoring unit (1) and first switches (2 and 3) disposed on either side of the monitoring unit (1),
- a switching bridge (5) that has a second switch (6) and bridges the series circuit, and
- a control knob (8) that prevents the removal of the monitoring unit (1) in the event that the first switches (2 and 3) are in a closed position,
- wherein the first switches (2 and 3) and the second switch (6) can be actuated by means of a selector switch (7) connected to the control knob such that, starting from open first switches (2 and 3) and a closed second switch (6), firstly the first switches (2 and 3) are closed and then the second switch (6) is opened, and starting from closed first switches (2 and 3) and an open second switch (6), firstly the second switch (6) is closed and then the first switches (2 and 3) are opened.

## Revendications

1. Montage pour monter et démonter sans interruption de circuit une unité (1) de contrôle dans un circuit de commande sécurisé en technique de signalisation d'aiguillage d'une installation de chemin de fer,
**caractérisé par**
- un circuit série constitué de
l'unité ( 1 ) de contrôle et de premiers interrupteurs ( 2 et 3 ) disposés de part et d'autre de l'unité ( 1 ) de contrôle,
- un pont ( 5 ) de coupure, qui a un deuxième interrupteur ( 6 ) et qui shunte le circuit série et
- une manette ( 8 ) de manoeuvre, qui bloque le retrait de l'unité ( 1 ) de contrôle si les premiers interrupteurs ( 2 et 3 ) se trouvent dans l'état fermé,
- dans lequel les premiers interrupteurs ( 2 et 3 ) et le deuxième interrupteur ( 6 ) peuvent être actionnés au moyen d'un commutateur ( 7 ) relié à la manette de manoeuvre de manière à, en partant des premiers interrupteurs ( 2 et 3 ) ouverts et du deuxième interrupteur ( 6 ) fermé, fermer d'abord les premiers interrupteurs ( 2 et 3 ), puis ouvrir ensuite le deuxième interrupteur ( 6 ) et, en partant des premiers interrupteurs ( 2 et 3 ) fermés et du deuxième interrupteur ( 6 ) ouvert, fermer d'abord le deuxième interrupteur ( 6 ), puis ouvrir les premiers interrupteurs ( 2 et 3 ).
